# EUROPEAN PATENT APPLICATION

(11) **EP 0 567 939 A2**
(43) Date of publication of application: **03.11.1993**
(21) Application number: 93106589.0
(22) Date of filing: 22.04.1993
(51) Int. Cl.: H01L 21/306

(54) **Method of removing small particles from a surface**

(30) Priority: 29.04.1992 US 875871
(71) Applicant: TEXAS INSTRUMENTS INCORPORATED, Dallas Texas 75265 (US)
(72) Inventor: Douglas, Monte A., Coppell, TX 75019 (US)
(74) Representative: Schwepfinger, Karl-Heinz, Dipl.-Ing.

(57) **Abstract**

A method of removing particles from a surface, comprising the steps of providing a surface 5 having particles thereon, placing the surface in a flowing polar solution 3 and causing light rays having a wavelength of from about 170 to about 2000 nanometers to impinge upon the particles. The surface of the polar solution and the light rays an be disposed in an inert ambient. The surface and the particles in the polar solution can be agitated. An electrode 7 can be provided external to the polar solution to provide a positive charge on the particles in the polar solution. There is also provided a method of removing particles from a surface, comprising the steps of providing a vessel 1 having a polar composition 3 flowing therein, placing a surface 5 having particles thereon in the flowing polar composition, providing an electrode 7 electrically insulated from the surface and providing a positive charge on the electrode. The electrode 7 can be disposed external to the vessel 1. The polar composition 3 is preferably clean water.

## Description

### BACKGROUND OF THE INVENTION

### FIELD OF THE INVENTION

This invention relates to a method of removing particles from a surface and, more specifically, to a method of removing very small particles, primarily about 0.5 microns and smaller, from a surface, preferably but not limited to a wafer of semiconductor material.

### BRIEF DESCRIPTION OF THE PRIOR ART

In the fabrication of semiconductor devices, particles disposed on the wafer surface which have been deposited thereon from the ambient atmosphere and possibly elsewhere have presented problems, such as, for example causing short circuits and the like when the particles were of supermicron length or about one micron and greater in length. The reason is that these particles have been in the dimension range of the geometrical dimensions involved in the devices being fabricated. For example, it is well known that it is necessary that the size of such particles must be less than one half the spacing between photolithographic lines to minimize yield problems caused by such particles. Past approaches to particle control have involved reduction of the number of these supermicron particles as opposed to complete removal of such particles since particle reduction alone allowed for reasonably high yields and further particle removal was not economically justified. Furthermore, particles of the type referred to above are not easily removable and often adhere to the semiconductor surface with a force on the order of tons per square inch.

One manner of minimizing this problem has been to perform the fabrication process in a "clean" environment or "clean room" wherein the particles are removed from the atmosphere entering the area in which fabrication takes place, thereby minimizing the deposit of such particles and avoiding particle contamination in the first place. Another way of minimizing this problem has been to agitate the particle contaminated surface in a surfactant solution, such as megasonics agitation in an SC-1 solution (NH₄/H₂O₂/H₂O), which has proven effective in the removal of certain types and sizes of particulate matter, generally of the supermicron size.

Such prior art procedures have operated effectively in the micron dimension range and above. However, semiconductor fabrication techniques are constantly improving and are now permitting fabrication of components with dimensions in the submicron range. Dimensions as low as about 0.1 microns are forseen in the immediate future with the possibility that even smaller dimensions will be obtainable in the more distant future. Unfortunately, as the dimensions of the components decrease, very small particles in the submicron range, which may not have presented a problem in the larger dimensioned components of the prior art and which were not consciously removed in the past, now present a severe yield, performance and reliability problem because they approach the dimensions of the geometries involved and the photolithographic dimensions being utilized. Such particles are not as easily removed by "clean rooms" or by other techniques used in the prior art in conjunction with micron and supermicron range dimensions. In fact, it is presently difficult, if not impossible, to eliminate the presence of these particles from the semiconductor fabrication facility, especially in view of the fact that most such particles come from processes and equipment in the fabrication facility. It has even been suggested that it might be impossible to remove such small particles once they have adhered to a surface. It is therefore apparent that new techniques are required for fabrication of the next generations of semiconductor components wherein dimensions are in the submicron range.

A review of the prior art for particle removal is set forth in Particle Control For Semiconductor Manufacturing, by R. P. Donovan, 1990, Marcel Dekker, Inc., pp. 371 to 379.

### SUMMARY OF THE INVENTION

In accordance with the present invention, there is provided a method of removing submicron (about 0.5 microns and below) particles from surfaces and particularly from semiconductor wafer surfaces. Such fine particles can come from one or more of several different sources and have properties which have not been well characterized at this time as to their shape, constitution, etc. These properties vary widely and are environment related. In other words, 0.5 micrometer and small particles found in etch processing are chemically and physically different from those found in lithography, ion-implant or sputter-deposition processing, for example. Also, apart from equipment and process induced particles, there are human clean room particles. Human particles, such as from dry skin, cosmetics, smoking, etc. are chemically and physically quite different also. Such submicron particles are attracted to a surface by extremely strong short-range forces which are on the order of tons per square inch, cannot be removed by prior art methods for small, supermicron to micron, particle removal and are not readily removable from the wafer surface. It should be understood that, though the invention will be described in connection with the fabrication of semiconductor devices, it also has applicability wherever it may be desirable to remove submicron size particles from a surface.

Briefly, in accordance with a first embodiment of the invention, a semiconductor wafer is disposed in a vessel submerged in liquid, preferably in a polar solution, preferably water, aqueous solutions of NH₄OH/H₂O₂/H₂O or alcohols, such as, for example, isopropyl alcohol and preferably a flowing solution. A metal plate, which is electrically insulated from the semiconductor wafer by a thin electrically nonconductive membrane or the like and, which can be external to the vessel with the vessel acting as the membrane or within the vessel and beneath the water, is electrically charged. By imposing a positive potential between the metal plate under the wafer and the polar solution, a counter charge builds up on the opposite side of the wafer with the charge carriers being OH⁻, for example. Sites on particles are energetically favorable toward accepting charge and/or chemically reactive with the reactive charge carrier. As the particles are charged, the polar solvent more readily solvates the particles, overcoming other forces that hold the particles to the wafer and liberating the particles into the solution to be carried out of the cleanup vessel.

Numerous variations of the above described first embodiment can be envisaged, these including discharging the metal plate to create a charge imbalance that would displace the charged particles from the surface of the wafer. Alternatively, the metal plate potential can be changed from positive to negative, for example, at a frequency that would maximize particle removal. All of the approaches consistent with the above described first embodiment are effective for the smallest of particles since the effective agent of removal is the molecular (atomic) anion or cation of the solution. Particle removal can be improved by concurrently agitating the solution, such as, for example, by ultrasonic agitation.

The invention as described above takes advantage of chemical, electrostatic and solvation forces instead of kinetic force to remove particles. Plain water which can be acquired in extremely clean (e.g. 18 mohm resistivity with point of use particle filters) form can be used. The invention herein removes particles of much smaller size than is possible in accordance with prior art methods and removes particles which are bound by very strong forces to a surface which agitation can not dislodge. Extremely high purity water can be used, thereby being very economical, safe and not posing a chemical disposal problem.

In accordance with a second embodiment of the invention, the particles are removed from the wafer by photostimulation wherein the wafer with particles thereon is submerged in a polar solution, such as, for example water, aqueous solutions, such as NH₄OH/H₂O₂, alkaline aqueous solutions, alcohols, etc., preferably clean water as above defined, as in the first embodiment and light having a wave length in the range of from about 170 nanometers to about 2000 nanometers and possibly even greater is caused to impinge upon the surface of the wafer containing the particles thereon and the particles. The source of light can be, for example, a microwave-excited discharge lamp having a color temperature of about 10,000°K. The light can be either continuous wave or pulsed with an intensity of from about 0.001 milliwatt to about 1 watt/cm² and preferably 200 to 300 milliwatt/cm² for about 1 second to about 10 minutes and preferably about 60 seconds. Shorter light wavelengths are more efficient for particle removal, in general. It is believed that the shorter the wavelength of light used with concomitant increased energy of the photons, the greater will be the ability to remove particles with a lower wavelength cutoff at about 170 nanometers because the polar solution begins to absorb the light at about 170 to about 200 nanometers and below. In addition, oxygen tends to absorb the light at the lower wavelengths. Accordingly, increased light energy is also provided at the lower wavelengths (i.e., about 170 to about 200 nanometers) by maintaining an inert ambient, preferably nitrogen, over the polar solution and preferably over the total distance of light travel from the light source to the polar solution. The light, in conjunction with the polar solution surrounding the particles, causes the particles to ionize. Solvation forces acting on the ionized particles on the surface overcome the forces of attraction between particle and surface and permits them to (a) be removed from the surface and then (b) be carried off by the flowing water. An electrode of polarity opposite to that described in the first embodiment, (-) potential, can be imposed to help stabilize formation of (+) ions. Furthermore, an electrode of (+) potential may help to eject (+) ions on the opposing side of the wafer. A combination of types of bias or alternating (+) and (-) biases could be used. When a wafer is placed in the same flowing water without the light impinging thereon, there does not appear to be any significant particle removal.

The fact that the water is flowing water is primarily for the purpose of carrying away particles once removed from a surface and is not integral to the particle removal from the surface itself. Flow rates in the range of from about 1 to about 1000 cm³/minute have been found to provide good results.

A possible theory of operation of the second embodiment is based upon the fact that the particles are attracted to the wafer by a very strong force on the order of tons per square inch. It is necessary to provide a counter force on the particles which is sufficiently strong to overcome the attractive force to remove the particles from the wafer. This is accomplished by applying solvation forces to the ionized particle to overcome the attractive forces toward the surface. The particles, when examined, are found to generally have some sharp edges as opposed to having a totally curvilinear surface. Accordingly, the energy required to remove an electron to create a positive charge on the particle is reduced due to the sharp point or points. By placing the wafer with particles thereon in a polar solution with dipoles, the positive charge is solvated or surrounded by negative charge which helps to quench the positively-charged product to which it is going. This further reduces the amount of energy required to ionize the particle, i.e., to create a positive charge plus an electron, and the solvation effect plays a dual role by also reducing the attraction of the particle to the wafer surface. Therefore, the light impinges upon the particles, creating ionized particles at a lower energy due to (a) sharp edges and (b) solvation effects. Upon particle ionization, the solvation forces in a polar solvent play a second role in this process by overcoming the attractive interaction forces between the particle and the substrate upon which it resides. As a result, the positively charged particle is removed from the substrate, goes into solution and is removed by the flowing polar solution, preferably clean water. As with the first embodiment, agitation will also assist in removing more particles. Also, an electrode can be used to further aid in particle removal.

### BRIEF DESCRIPTION OF THE DRAWINGS

FIGURE 1 is a schematic diagram of an apparatus for use in conjunction with a first embodiment of the invention; and
FIGURE 2 is a schematic diagram of an apparatus for use in conjunction with a second embodiment of the invention.

### DESCRIPTION OF THE PREFERRED EMBODIMENTS

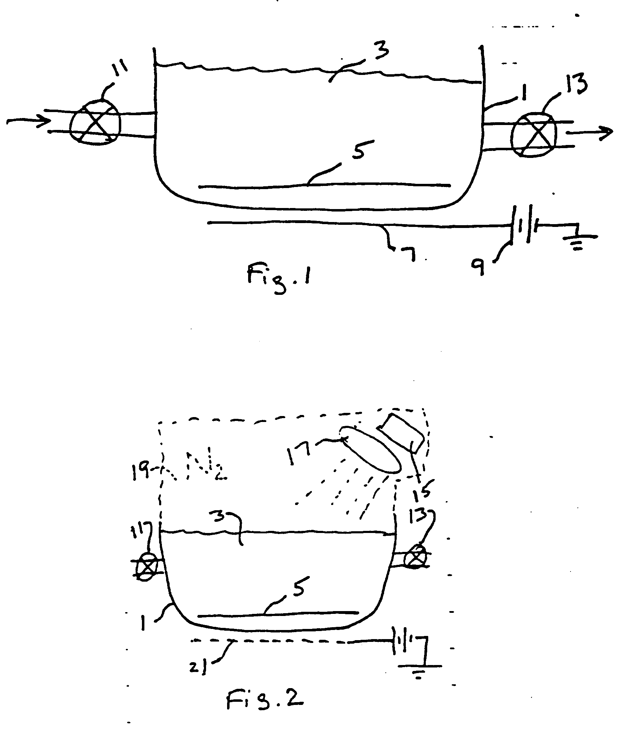

Referring first to FIGURE 1, there is shown an apparatus for removing particles from a surface in accordance with a first embodiment of the present invention. There is shown a vessel 1 containing water 3 in very clean form. A semiconductor wafer 5 is disposed in the bottom of the vessel 1 and completely covered with the water. A metal plate 7, preferably of copper, is disposed closely adjacent the wafer 5 and electrically insulated therefrom. The metal plate 7 is preferably external of the vessel 1 though it can be within the vessel and adjacent the wafer 5 as long as there is electrical insulation from the particles on the wafer. The metal plate 7 is connected to a battery 9 which can be direct current as shown or an alternating current source of desired frequency. The water 3 can be made stagnant by closing the valves 11 and 13 or circulated in the vessel 1 by opening the valves and pumping the water into and out of the vessel. The otherwise stagnant water 3 can also be moved in the vessel 1 when the valves 11 and 13 are closed by agitation thereof, such as by ultrasonic agitation or by use of a moving blade or the like within the water. Greatly improved results are obtained when the water 3 is moving.

In an example, using the apparatus of FIGURE 1 with the vessel 1 filled with very clean water 3, a wafer 5 having a radius of 0.05 meter, the distance between the wafer and the electrode 7 of 0.001 meter and 100 volts being applied to the electrode 7 relative to the wafer, which is grounded, the capacitance between the wafer and the electrode was calculated to be 1.748 x 10⁻¹⁰ farads, the charge on the wafer was calculated to be 1.748 x 10⁻⁸ coulombs and the number of hydroxyl anions/cm² on the wafer surface was calculated to be 1.092 x 10¹¹.

The positive charge on the plate 7 forces a negative charge on the wafer 5. In a water solution 3, the negative charge is manifested as hydroxyl radicals and builds up an accumulation layer of an alkaline solution along the surface of the wafer 5. The hydroxyl radicals are very reactive. Therefore, if there is a particle on the surface of the wafer, with the hydroxyl radical being very caustic, there can be a reaction with the particle to provide a negatively charged species. By solvation effects in the polar solution 3, the attractive force between the particle and the wafer surface is counteracted and the particle is removed from the surface and carried away by the flowing water.

Referring now to FIGURE 2 there is shown a second embodiment of the invention. In accordance with this embodiment, there is provided a vessel 1 having clean water 3 therein and a wafer 5 under the water as in the first embodiment. Water can be made to flow through the vessel 1 by operation of the valves 11 and 13 as in the first embodiment. Light having an intensity of 1 milliwatt/cm² and a wavelength between 200 and 300 nanometers is made to impinge upon the wafer 5 for 60 seconds by means of a light source 15 via optics 17. The combination of light from light source 15 and polar solution 3 simultaneously contacting the particles on the surface of the wafer 5 counteracts the attractive force between the particles and the wafer surface and permits the flowing water 3 to be released from the wafer surface and travel out of the vessel 1 along with the flowing water. Additionally, with the water 3 moving at 5 cm³/minute, the number of particles measured on the wafer prior to cleaning was 640 particles/cm² whereas the number of particles measured on the wafer after cleaning as noted above was 81 particles/cm².

As a variation, the atmosphere or ambient above the vessel 1 and preferably including the light source 15 and/or all or part of the light path from the light source to the wafer 5 is disposed in an inert atmosphere 19, preferably nitrogen rather than ordinary air. This removes the oxygen from the atmosphere and permits operation with a light source 15 having lower wavelength as discussed hereinabove.

As a further variation, the counteracting force provided to the particle as discussed above with reference to the second embodiment may not be sufficiently large to overcome the attractive force. However, the particle can still be separated from the wafer by applying an additional agitating force to the particle, such as an ultrasonic vibration provided by a standard 20 KHz ultrasonic/megasonic 600 to 900 KHz element as used in the prior art systems as set forth in the above noted publication to provide the additional force required for particle separation from the wafer.

As a still further variation, an electrode 21 is positioned beneath the vessel 1 and negatively charged as shown in FIGURE 2. This assists in building up the positive charges on the surface of the wafer 5 and/or ejecting the charged particles by choice of polarity.

Also, in both of the above described embodiments, the polar solution exiting the vessel 1 via valve 13 can be cleaned and recycled back to the valve inlet 11.

Though the invention has been described with respect to specific preferred embodiments thereof, many variations and modifications will immediately become apparent to those skilled in the art. It is therefore the intention that the appended claims be interpreted as broadly as possible in view of the prior art to include all such variations and modifications.

## Claims

1. A method of removing particles from a surface, comprising the steps of:
(a) taking a surface having particles thereon;
(b) placing said surface in a liquid; and
(c) causing radiation having a wavelength of from about 170 to about 2000 nanometers to impinge upon said particles.

2. The method of claim 1, further comprising providing said liquid as a polar solution.

3. The method of claim 2, further comprising causing said polar solution to flow over said surface.

4. The method of claim 2 or claim 3, further comprising providing said polar solution as water.

5. The method of any of claims 2 to 4, further including disposing the surface of said polar solution and said radiation in an inert ambient.

6. The method of any of claims 2 to 5, further including the step of agitating said surface and said particles in said polar solution.

7. The method of any of claims 2 to 6, further including the step of providing an electrode external to said polar solution to provide a positive charge on said particles in said polar solution.

8. The method of any preceding claim, further comprising the step of:
providing a vessel having the liquid flowing therein, into which the surface is placed in use.

9. The method of claim 8, further comprising providing said electrode disposed external to said vessel.
